(19) Europäisches Patentamt
European Patent Office
Office européen des brevets

(11) **EP 4 503 889 A1**

(12) **EUROPEAN PATENT APPLICATION**

(43) Date of publication:
**05.02.2025 Bulletin 2025/06**

(21) Application number: **24162998.9**

(22) Date of filing: **12.03.2024**

(51) International Patent Classification (IPC):
**H10K 30/40** *(2023.01)* **H10K 30/81** *(2023.01)*

(52) Cooperative Patent Classification (CPC):
**H10K 30/40; H10K 30/81;** H10K 85/50

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.08.2023 JP 2023125470**
**05.03.2024 JP 2024032815**

(71) Applicant: **Kabushiki Kaisha Toshiba**
**Minato-ku**
**Tokyo (JP)**

(72) Inventors:
• **SHIMO, Shunsuke**
**Tokyo (JP)**
• **MORI, Shigehiko**
**Tokyo (JP)**
• **WADA, Atsushi**
**Tokyo (JP)**
• **AMANO, Akio**
**Tokyo (JP)**

(74) Representative: **Marks & Clerk LLP**
**15 Fetter Lane**
**London EC4A 1BW (GB)**

(54) **PHOTOELECTRIC CONVERSION ELEMENT**

(57) A photoelectric conversion element in an embodiment, includes: a substrate; a first electrode; a photoelectric conversion film containing a perovskite crystal having a composition expressed by $ABX_3$; an electron transport layer; and a second electrode. The second electrode includes: a first layer arranged on the electron transport layer and containing at least one first metal selected from Ti, Sn, Zn, Ce, In, and Nb and an oxide of the first metal; and a second layer containing a second metal and an oxide of the second metal. The second layer includes: a first region existing on the first layer side; a second region existing on the first region and having a lower oxygen concentration than the first region; and a third region existing on the second region and having a higher oxygen concentration than the second region.

FIG. 1

EP 4 503 889 A1

# EP 4 503 889 A1

**Description**

FIELD

Embodiments disclosed herein relate to a photoelectric conversion element.

BACKGROUND

Photoelectric conversion elements such as a solar cell, a photosensor, a light-emitting element, a photodiode, and an optical memory using perovskite-type materials as a photoelectric conversion material are expected as low-cost photoelectric conversion elements because an inexpensive coating method can be applied for formation of layers. Of the perovskite-type materials used as the photoelectric conversion material, a perovskite crystal having a composition expressed by $ABX_3$ and having a three-dimensional crystal structure is excellent in photoelectric conversion efficiency, and a solar cell and the like improved in conversion efficiency using the perovskite crystal are reported. A problem of the solar cell is the corrosion resistance, conductivity, and the like of the electrode (cathode) formed on the photoelectric conversion layer.

The photoelectric conversion element using the perovskite-type material has, for example, a structure in which an anode, a photoelectric conversion layer, an electron transport layer, and a cathode are stacked on a transparent substrate. In the photoelectric conversion element, a laminated structure of a layer containing chromium (Cr) and a Cr oxide and a layer of gold (Au), copper (Cu), aluminum (Al), or the like formed thereon, is proposed as the cathode. However, the Cr oxide is a p-type semiconductor, so that when it is arranged on the electron transport layer side, it becomes a barrier of electron transport and thus will cause a decrease in efficiency. Further, since only one layer containing an oxide is arranged in the cathode, the block ability from the external environment cannot be sufficiently enhanced. Therefore, the Au layer and the like on the upper layer side are likely to progressively deteriorate due to corrosion from the external environment.

SUMMARY

A problem to be solved by embodiments of the present invention is to provide a photoelectric conversion element sufficiently enhanced in block ability from the external environment and thereby suppressed in characteristic deterioration, and improved in electronic efficiency and conductivity.

According to the embodiments of the present invention, a photoelectric conversion element sufficiently enhanced in block ability from the external environment and thereby suppressed in characteristic deterioration, and improved in electronic efficiency and conductivity is provided.

BRIEF DESCRIPTION OF THE DRAWINGS

FIG. 1 is a cross-sectional view illustrating a first example of a photoelectric conversion element in an embodiment.
FIG. 2 is a cross-sectional view illustrating a second example of a photoelectric conversion element in the embodiment.
FIG. 3 is an I-V curve graph of the photoelectric conversion element in Example 1.
FIG. 4 is an I-V curve graph of the photoelectric conversion element in Comparative example 1.
FIG. 5 is a macrophotograph illustrating an appearance of an Al electrode after 100 hours from the fabrication of the photoelectric conversion element in Example 1.
FIG. 6 is a macrophotograph illustrating an appearance of the Al electrode after 100 hours from the fabrication of the photoelectric conversion element in Comparative example 1.
FIG. 7 is a chart illustrating an XPS analysis result of the Al component at positions corresponding to a third region, a second region, and a first region at the Al electrode of the photoelectric conversion element in Example 1.
FIG. 8 is a chart illustrating an XPS analysis result of a Ti component near the first region of the photoelectric conversion element in Example 1.
FIG. 9 is graphs indicating element abundance ratios of the Al electrode and a Ti electrode in the photoelectric conversion element in Example 1.
FIG. 10 is a chart indicating an XPS analysis result of the Al component at positions corresponding to the third region, the second region, and the first region at the Al electrode of the photoelectric conversion element in Comparative example 1.
FIG. 11 is graphs indicating element abundance ratios of the Al electrode and the Ti electrode in the photoelectric conversion element in Comparative example 1.

## DETAILED DESCRIPTION

A photoelectric conversion element in an embodiment includes: a substrate; a first electrode arranged on the substrate; a photoelectric conversion film arranged on the first electrode and containing a perovskite crystal having a composition expressed by

a composition formula: $ABX_3$

where, A represents a monovalent cation of an amine compound, B represents a divalent cation of a metal element, and X represents a monovalent anion of a halogen element; an electron transport layer arranged on the photoelectric conversion film; and a second electrode arranged on the electron transport layer. In the photoelectric conversion element in the embodiment, the second electrode includes: a first layer arranged on the electron transport layer and containing at least one first metal selected from the group consisting of titanium, tin, zinc, cerium, indium, and niobium and an oxide of the first metal; and a second layer arranged on the first layer and containing a second metal and an oxide of the second metal; and the second layer includes: a first region existing on the first layer side; a second region existing on the first region and having a lower oxygen concentration than the first region; and a third region existing on the second region and having a higher oxygen concentration than the second region.

Hereinafter, a photoelectric conversion element and its manufacturing method in embodiments will be explained with reference to the drawings. In the embodiments, substantially the same components are denoted by the same reference signs and the explanation thereof will be partially omitted in some cases. The drawings are schematic in which the relationship between the thickness and planar dimensions, a thickness ratio among the components and so on may be different from actual ones. Terms indicating directions such as up and down in the explanation indicate relative directions when a later-explained formation surface of each layer of a substrate is up unless otherwise specified, and may be different from the actual direction with the gravitational acceleration direction as a reference.

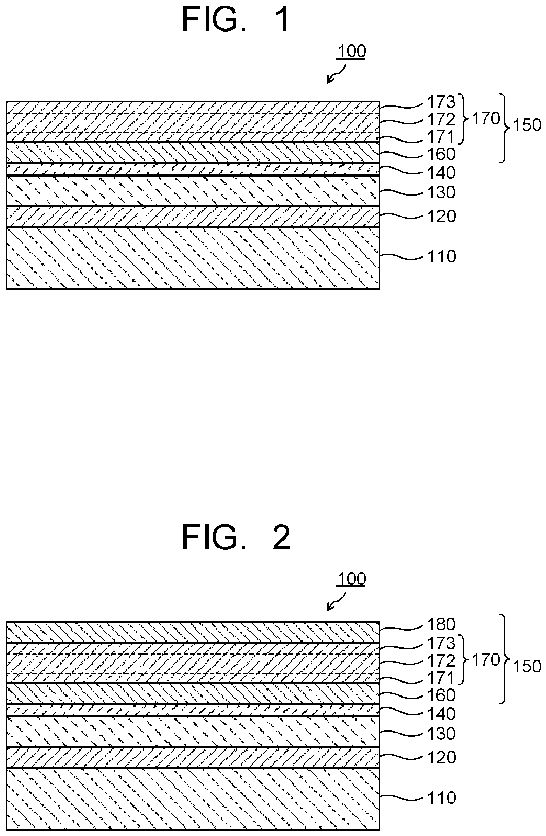

FIG. 1 is a cross-sectional view illustrating a first example of the photoelectric conversion element in the embodiment. A photoelectric conversion element 100 illustrated in FIG. 1 includes a transparent substrate 110 as a support substrate, a first electrode 120 arranged on the transparent substrate 110, a photoelectric conversion layer 130 arranged on the first electrode 120, an electron transport layer 140 arranged on the photoelectric conversion layer 130, and a second electrode 150 arranged on the electron transport layer 140. The constituent layers will be explained in detail below.

Since the photoelectric conversion element 100 is assumed to use the second electrode 150 irradiated with light from the lower side in the drawing here, the transparent substrate 110 is used for the support substrate. For the transparent substrate 110, a material having light transmitting property and insulation property. For the constituent material of the transparent substrate 110, an inorganic material such as no-alkali glass, quartz glass, or sapphire, or an organic material such as polyethylene (PE), polyethylene terephthalate (PET), polyethylene naphthalate (PEN), polyimide, polyamide, polyamideimide, or liquid crystal polymer is used. The transparent substrate 110 may be a rigid substrate composed of an inorganic material or an organic material, or may be a flexible substrate composed of an organic material or an ultra-thin inorganic material.

The first electrode 120 arranged on the transparent substrate 110 is a transparent electrode as an anode and is composed of a material having light transmitting property and conductivity. Examples of the constituent material of the first electrode 120 include conductive metal oxides such as indium oxide, zinc oxide, tin oxide, indium tin oxide (ITO), fluorine-doped tin oxide (FTO), indium-zinc oxide (IZO), and indium-gallium-zinc oxide (IGZO), conductive two-dimensional layer chemical compounds such as titanium carbide and titanium aluminum carbide, thin films of metals such as gold, platinum, silver, copper, titanium, zirconium, cobalt, nickel, indium, and aluminum, and alloys containing the metals, conductive polymer materials such as poly(3, 4-ethylenedioxythiophene)/poly(4-styrenesulfonic acid) (PEDOT/PSS), carbon compounds such as graphene and carbon nanotube, and so on. The first electrode 120 is formed, for example, by a vacuum deposition method, a sputtering method, an ion plating method, a plating method, a coating method, or the like.

The photoelectric conversion layer 130 is a perovskite crystal layer. The perovskite crystal has a composition expressed by Formula (1) below and has a three-dimensional crystal structure.
Composition formula:

$$ABX_3 \ldots \qquad (1)$$

In Formula (1), A represents a monovalent cation of an amine compound, B represents a divalent cation of a metal element, and X represents a monovalent anion of a halogen element.
Perovskite-type crystal structures are divided into four types such as a zero-dimensional structure to a three-dimensional structure. A two-dimensional structure having a composition expressed by $A_2BX_4$ and a three-dimensional structure having a composition expressed by $ABX_3$ are advantageous in terms of obtaining a highly efficient photoelectric conversion material and a photoelectric conversion element using it. The three-dimensional structure of them is known to be low in bound energy of an exciton, and is more preferable in obtaining the highly efficient photoelectric conversion material and the photoelectric conversion element. It is known that the perovskite crystal takes the two-dimensional structure when the ion radius of an A site is large, and takes the three-dimensional structure when the ion radius is small.

It is experientially known that when an A site ion has an ion radius where a tolerance factor t falls between 0.75 to 1.1, a perovskite-type crystal in the three-dimensional structure is formed. The tolerance factor t is a value expressed by Formula (2) below. There are some types of ion radii, an ion radius of Shannon is used.

$$t = (\text{A site ion radius} + \text{X site ion radius})/\{2^{1/2} \times (\text{B site ion radius} + \text{X site ion radius})\} \dots (2)$$

To satisfy the condition of the A site ion as above, the A site is composed of a monovalent cation of an amine compound. The amine compound constituting the A site is preferably one selected from methylammonium ($CH_3NH_2$) and formamidinium ($NH_2CHNH$). The B site is composed of a divalent cation of a metal element, and the X site is composed of a monovalent anion of a halogen element. The metal element constituting the B site is preferably at least one selected from lead (Pb) and tin (Sn). The halogen element constituting the X site is preferably at least one selected from iodine (I), bromine (Br), and chlorine (Cl). These provide a high photoelectric conversion efficiency.

The thickness of the photoelectric conversion layer 130 is preferably in a range of 10 to 1000 nm. For the photoelectric conversion layer 130, it is possible to apply a coating method of a photoelectric conversion material dispersion liquid for forming a perovskite crystal layer by applying a dispersion liquid of a coating liquid (perovskite crystal) obtained by dispersing a photoelectric conversion material such as a perovskite crystal in a dispersion liquid, on the transparent substrate 110, scattering the dispersion liquid, and drying it. A coating mechanism of the photoelectric conversion material dispersion liquid only needs to be a method (and a mechanism) capable of supplying the photoelectric conversion material dispersion liquid on a film forming object with a uniform thickness and, for example, a liquid application method such as a spin coating method, a slit coating method, a screen printing method, a spray method, a meniscus coating method, or the like can be applied.

The photoelectric conversion layer 130 is irradiated with light such as sunlight or illumination light, for example, from the transparent substrate 110 side. When the photoelectric conversion layer 130 composed of the perovskite crystal layer absorbs the light radiated to the photoelectric conversion element 100, electrons and holes paring with them are generated. For example the electrons of the electrons and the holes generated in the photoelectric conversion layer 130 are collected by the second electrode (cathode) 150 via the electron transport layer 140, and the holes are collected by the first electrode (anode) 120. Between the first electrode 120 and the photoelectric conversion layer 130, a hole transport layer may be arranged.

The electron transport layer 140 has a function of blocking the holes generated in the photoelectric conversion layer 130 and selectively and efficiently transporting the electrons to the second electrode 150. For the electron transport layer 140, a metal oxide such as zinc oxide, titanium oxide, or gallium oxide, a fullerene derivative such as fullerene $C_{60}$, $C_{70}$, a fullerene metal complex, [6,6]phenyl $C_{61}$ butyric acid methylester (PC60BM), [6,6]phenyl $C_{71}$ butyric acid methylester (PC70BM), or bis-indene $C_{60}$ (60ICBA), an organic material such as polyethyleneimine, perylenediimide derivative, or naphthalene diimide derivative, or the like is used. In the case of applying the hole transport layer, the hole transport layer has a function of blocking the electrons generated in the photoelectric conversion layer 130 and selectively and efficiently transporting the holes to the first electrode 120. For the hole transport layer, an organic conductive polymer such as PEDOT/PSS, polythiophene, polytolylamine, polypyrrole, triphenylenediaminepolypyrrol, or polyaniline, a metal oxide such as nickel oxide, copper oxide, tungsten oxide, molybdenum oxide, or vanadium oxide, a phosphoric acid part or carboxylic acid capable of forming a chemical bond with the first electrode 120, a carbazole compound having a silyl ester site, a polycyclic aromatic compound, or the like is used. The electron transport layer is formed by a vacuum film forming method such as a vacuum deposition method or a sputtering method, a sol-gel method, a coating method, or the like. The hole transport layer is also the same.

The second electrode 150 is composed of a material having conductivity, and having light transmitting property in some cases. The second electrode 150 includes: a first layer 160 arranged on the electron transport layer 140 and containing at least one first metal selected from the group consisting of titanium (Ti), tin (Sn), zinc (Zn), cerium (Ce), indium (In), and niobium (Nb), and an oxide of the first metal; and a second layer 170 arranged on the first layer 160 and containing a second metal and an oxide of the second metal. The second metal is preferably at least one selected from the group consisting of metals having higher conductivity than the first metal, such as aluminum (Al), molybdenum (Mo), nickel (Ni), copper (Cu), and silver (Ag). Each layer of the second electrode 150 is formed by a vacuum film forming method such as a vacuum deposition method or a sputtering method.

The second layer 170 in the second electrode 150 includes a first region 171 existing on the first layer 160 side, a second region 172 existing on the first region 171, and a third region 173 existing on the second region 172. The first region 171 has a higher oxygen concentration than the second region 172. In other words, the second region 172 has a lower oxygen concentration than the first region 171. Further, the third region 173 has a higher oxygen concentration than the second region 172. The first region 171 and the third region 173 preferably have not a state of simply containing oxygen or a state where oxygen is simply absorbed on their surfaces but a state where the second metal and oxygen bond together. The first region 171 and the third region 173 having this state are excellent in corrosion resistance.

In the first layer 160 of the second electrode 150, an oxide of at least any one first metal selected from the group consisting of Ti, Sn, Zn, Ce, In, and Nb constituting the layer exhibits the property as an n-type semiconductor, and therefore does not inhibit the electrons generated in the photoelectric conversion layer 130 from being collected by the second electrode (cathode) 150 via the electron transport layer 140 but promotes the movement of the electrons. Accordingly, the efficiency of the photoelectric conversion element 100 is enhanced. Further, the oxide of the first metal is excellent in corrosion resistance and therefore contributes to an improvement in corrosion resistance of the second electrode 150.

For example, the second layer 170 containing the second metal having higher conductivity than the first metal and the oxide of the second metal is formed on the first layer 160 containing the first metal and the oxide of the first metal, and the second electrode 150 is made into a laminated electrode of the first layer 160 containing the oxide of the first metal and the second layer 170 containing the oxide of the second metal, thereby making it possible to enhance the block ability from the external environment. Accordingly, it becomes possible to improve the electronic efficiency in the photoelectric conversion element 100 and sufficiently enhance the block ability of the second electrode 150 with respect to the external environment to suppress characteristic deterioration due to contamination or the like of the second electrode 150 from the external environment.

Further, the second layer 170 in the second electrode 150 includes the first region 171 existing on the first layer 160 side, the third region 173 existing on the outermost layer side, and the second region 172 existing between them, and the first region 171 and the third region 173 have higher oxygen concentrations than the second region 172. By applying the first region 171 and the third region 173, the block ability and the like of the second layer 170 with respect to the external environment can be improved. Further, the oxygen concentration of the second region 172 existing between them is made lower than those of the first region 171 and the third region 173, so that the conductivity of the second layer 170 by the second region 172 can be enhanced. In other words, it is possible to provide the photoelectric conversion element 100 including the second electrode 150 enhanced in corrosion resistance by improving the conductivity originally required for the electrode and the block ability with respect to the external environment.

In the second electrode 150, the first layer 160 preferably has a thickness of 1 nm or more and 50 nm or less, and the second layer 170 preferably has a thickness of 20 nm or more and 400 nm or less. Further, in the second layer 170, the first region 171 preferably has a thickness of 1 nm or more and 30 nm or less, the second region 172 preferably has a thickness of 10 nm or more and 398 nm or less, and the third region 173 preferably has a thickness of 1 nm or more and 30 nm or less. The thicknesses of the first region 171, the second region 172, and the third region 173 in the second layer 170 can be determined by an energy dispersive X-ray spectroscopy (TEM-EDX) by a transmission electron microscopy analysis in a cross sectional direction or an X-ray photoelectron spectroscopy (XPS) in a depth direction combined with ion sputtering, or the like.

The first layer 160 and the second layer 170 in the second electrode 150 can be formed, for example, by the vacuum film forming method such as a vacuum deposition method or a sputtering method. For example, when forming the second electrode 150 using the vacuum deposition method, the oxygen concentration in each of the first region 171, the second region 172, and the third region 173 can be controlled by changing the pressure or the oxygen concentration in a film deposition chamber.

The second electrode 150 may further include a third layer 180 arranged on the second layer 170 and containing a third metal as illustrated in FIG. 2. As the third metal constituting the third layer 180, for example, a metal which is less likely to oxidize than the second metal can be used. Examples of the metal include at least one selected from the group consisting of copper (Cu), silver (Ag), and gold (Au). Applying the third layer 180 containing the third metal can further enhance the conductivity of the second electrode 150. Alternatively, a metal which is more likely to form a passive state than the second metal may be applied to the third metal. Examples of the metal include at least one selected from the group consisting of titanium (Ti), aluminum (Al), and molybdenum (Mo). By applying the third layer 180 containing the third metal, the third layer 180 formed into a passive state can further improve the corrosion resistance of the second electrode 150.

The photoelectric conversion element 100 in the embodiment includes the second electrode 150 improved in block ability and the like with respect to the external environment and thereby enhanced in corrosion resistance, and improved in electronic efficiency and conductivity. Accordingly, it is possible to provide a photoelectric conversion element 100 enhanced in conductivity, electronic efficiency, and corrosion resistance. The photoelectric conversion element 100 in the embodiment can be applied to a solar cell, a photosensor, a light-emitting element, a photodiode, an optical memory, and the like.

EXAMPLES

Next, examples and their evaluation results will be explained.

(Example 1)

[Fabrication of the photoelectric conversion element]

An ITO film was formed as the first electrode on a PET substrate, and then subjected to ultrasonic cleaning and UV cleaning in isopropyl alcohol and acetone. On the PET substrate having the ITO film, a hole transport layer including PEDOT:PSS having a thickness of about 50 nm was formed. For a solution of the hole transport layer, PEDOT:PSS (AI4083 (trade name) manufactured by Heraeus Co., Ltd.) was used. For film formation, a meniscus coating apparatus having a cylindrical applicator was used. The applicator was arranged so that a gap distance with respect to the PET substrate was 0.2 mm, and 7.5 μL of the solution of the hole transport layer was supplied to each coating region of the applicator to form a meniscus column. The coating solution was applied onto the PET substrate while controlling the angle of the PET substrate and the gap distance. The moving speed of the PET substrate was fixed at 8.0 mm/s. The hole transport layer solution was applied onto the PET substrate having the ITO film, and then heated in the atmosphere at 140°C for ten minutes to remove excessive solvent, thereby forming a hole transport layer. The film thickness of the hole transport layer is about 50 nm.

Next, a perovskite layer was formed as a photoelectric conversion layer as follows. First, a perovskite material solution (coating solution) was prepared by dissolving methylammonium iodide ($CH_3NH_3I$) and lead iodide ($PbI_2$) in N,N-dimethylformamide (DMF). The coating solution was prepared by setting a molar ratio between methylammonium iodide and lead iodide to 1: 1 so that the concentration in the solution was 45 mass%. For film formation, a meniscus coating apparatus having a cylindrical applicator was used. The applicator was arranged so that the gap distance with respect to the PET substrate was 0.2 mm, and 7.5 μL of the perovskite material solution was supplied to each coating region of the applicator to form a meniscus column. The coating solution was applied onto the PET substrate while controlling the angle of the PET substrate and the gap distance. The moving speed of the PET substrate was fixed at 100 mm/s, and a nitrogen gas at a wind speed of 6.0 m/s was sprayed, at the same time of the applications, onto the coating film by an air knife to dry the coating film. Thereafter, it was heated at 120°C for ten minutes to remove excessive solvent and grow crystals, thereby forming a photoelectric conversion layer of a perovskite crystal compound. The film thickness of the photoelectric conversion layer is about 500 nm.

Next, a solution of the electron transport layer was prepared by adding 1 mL of monochlorobenzene to 20 mg of 60PCBM. A coating head was arranged so that a gap distance with respect to the photoelectric conversion layer on the PET substrate was 0.5 mm. 40.0 μL of the solution of the electron transport layer was supplied to each coating region of the coating head to form a meniscus column. The coating solution was applied onto the PET substrate while controlling the angle of the PET substrate and the gap distance. The moving speed of the PET substrate was fixed at 8.0 mm/s. The solution of the electron transport layer was applied onto the ITO substrate, and then heated in the atmosphere at 100°C for ten minutes to remove excessive solvent, thereby forming an electron transport layer. The film thickness of the electron transport layer is about 50 nm.

Next, P2 scribing was performed by mechanical scribing. As a scribing tool, a cutting tool having a rectangular tip and a width of 80 μm was used. The scribing tool was pressed by a suspension mechanism using a spring and scanned in parallel with the longitudinal direction of the ITO film to perform 2P scribing to scribe three layers such as the electron transport layer, the perovskite layer, and the hole transport layer, thereby exposing the ITO film.

Next, film formation of the second electrode (counter electrode) was performed. Vacuum deposition of Ti was performed with a degree of vacuum set to $1 \times 10^{-3}$ Pa. The film thickness of the Ti layer is 10 nm. Subsequently, film formation of Al was performed by vacuum deposition at the same degree of vacuum. The film thickness of the Al layer is about 100 nm.

(Comparative example 1)

A photoelectric conversion element was fabricated as in Example 1 except that Ti was not deposited and Al was deposited at 100 nm by the vacuum deposition in the film formation of the second electrode (counter electrode) in Example 1.

[Initial conversion efficiency evaluation and evaluation after 100 hours of the photoelectric conversion element]

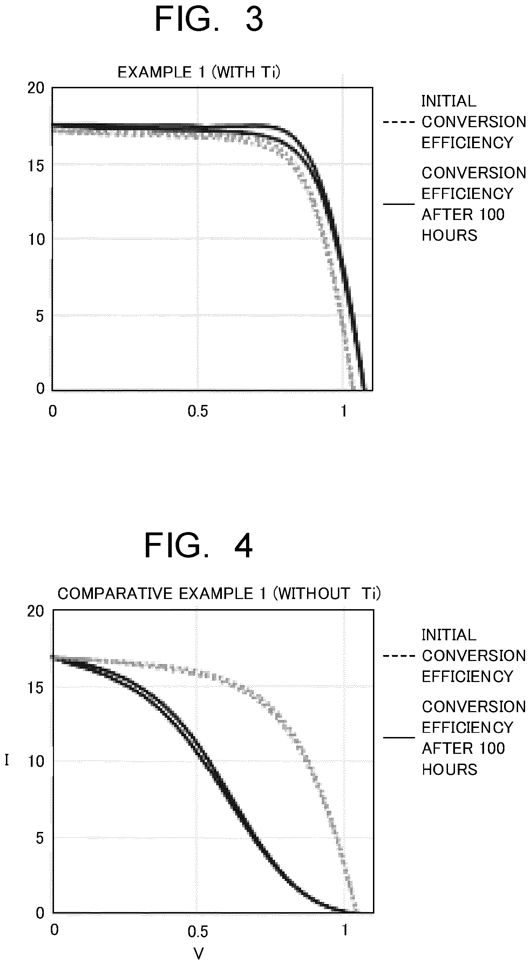

I-V characteristic was measured for each of the above photoelectric conversion elements in Example 1 and Comparative example 1. The measurement of the I-V characteristic was carried out using a solar simulator, at an irradiance of 100 mW/cm$^2$, and a reference spectrum of an air mass (AM) of 1.5 G. The initial conversion efficiency immediately after the element fabrication and the conversion efficiency after 100 hours from the fabrication were measured. The measurement results are indicated in FIG. 3, FIG. 4 and Table 1. FIG. 3 indicates I-V curves in Example 1 and FIG. 4 indicates I-V curves in Comparative example 1, in which a broken line indicates the initial conversion efficiency immediately after the element fabrication and a solid line indicates the conversion efficiency after 100 hours.

[Table 1]

|  | Example 1 | | Comparative example 1 | |
|---|---|---|---|---|
| Ti electrode | 10nm | | (without) | |
| Mesuring time | Immediate after fabrication | After 100 hours | Immediate after fabrication | After 100 hours |
| Conversion efficiency [%] | 12.7 | 13.7 | 10.3 | 5.69 |
| Short-circuit current density [mA/cm$^2$] | 17.3 | 17.5 | 16.8 | 16.8 |
| Open voltage [V] | 1.04 | 1.07 | 1.04 | 1.04 |
| Fill factor | 0.71 | 0.72 | 0.58 | 0.31 |
| Series resistance [Ω] | 6.32 | 7.43 | 11.5 | 33.6 |
| Parallel resistance [Ω] | 2721 | 9288 | 1330 | 31.6 |

[Observation of the counter electrode of the photoelectric conversion element]

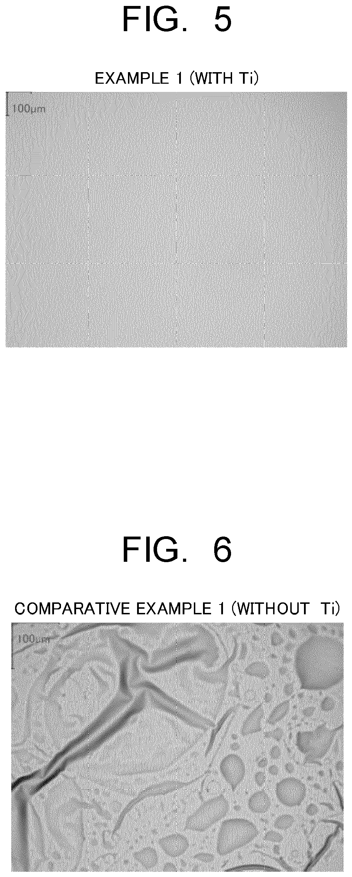

For the above photoelectric conversion elements, observation under an optical microscope was carried out. The appearance of the second electrode (counter electrode) after 100 hours from the fabrication was observed at an observation magnification of 10 times and a macrophotograph was captured. The results are indicated in FIG. 5, FIG. 6, and Table 2. FIG. 5 indicates the appearance of the Al electrode after 100 hours from the fabrication in Example 1, and FIG. 6 indicates the appearance of the Al electrode after 100 hours from the fabrication in Comparative example 1.

[Table 2]

|  | Example 1 | Comparative example 1 |
|---|---|---|
| Ti electrode | 10nm | (without) |
| Aspect of electrode after 100 hours from fabrication | Without change of aspect | Appearance of change of aspect |

[XPS measurement of the perovskite compound layer]

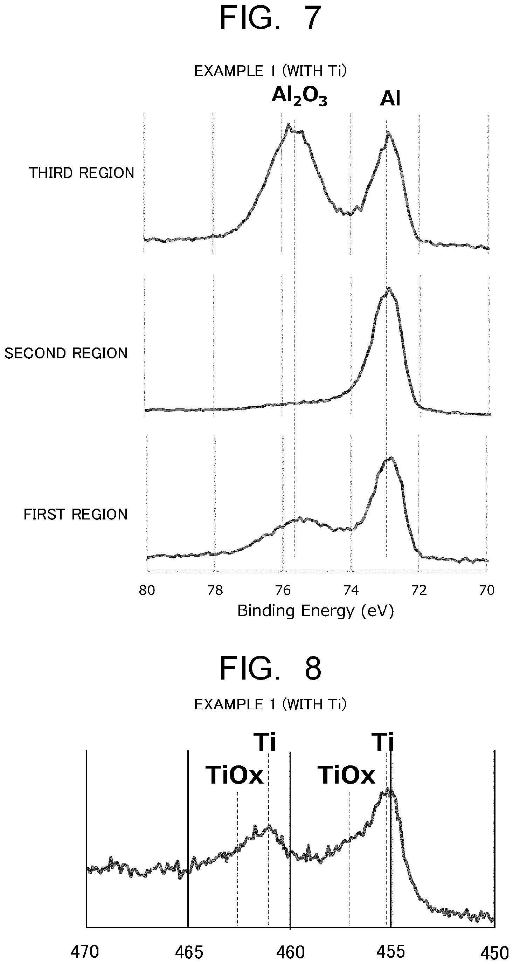

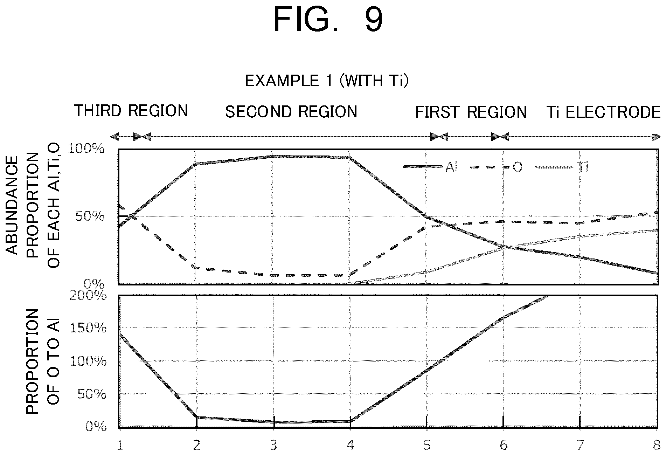

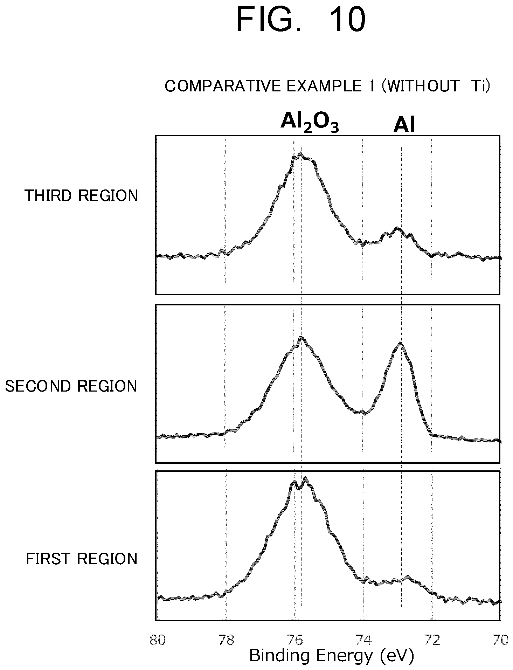

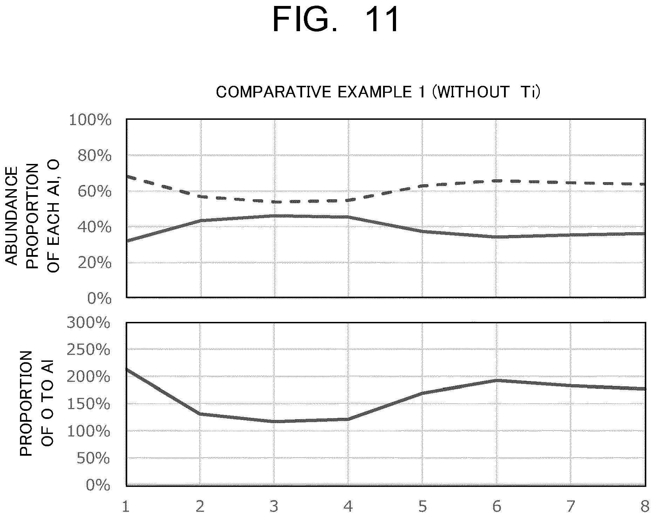

An XPS analysis of the photoelectric conversion element after 100 hours from the fabrication was carried out for the above photoelectric conversion elements. A composition analysis in the depth direction was carried out while cutting it in the film thickness direction by sputtering from the second electrode (cathode) side. Analysis results are indicated in FIG. 7 to FIG. 11. FIG. 7 indicates states of the Al component at positions corresponding to the third region, the second region, and the first region of the photoelectric conversion element in Example 1, and corresponds to signals of an aluminum oxide near 76 eV and a metal aluminum near 73 eV FIG. 8 indicates the Ti component near the first region and corresponds to signals of a metal titanium near 455 eV and 461 eV and a titanium oxide at 457 eV and 462 eV on a lower energy side than them. FIG. 9 is graphs regarding an element abundance ratio when using the horizontal axis as the depth direction, in which an upper one is a graph plotting the abundance proportion of each of Al, Ti, O on the vertical axis, and a lower one is a graph plotting a proportion of O to Al. FIG. 10 indicates a state of the Al component at positions corresponding to the third region, the second region, and the first region of the photoelectric conversion element in Comparative example 1, and corresponds to signals of an aluminum oxide near 76 eV and a metal aluminum near 73 eV FIG. 11 is graphs regarding an element abundance ratio when using the horizontal axis as the depth direction, in which an upper one is a graph plotting the abundance proportion of each of Al and O on the vertical axis, and a lower one is a graph plotting a proportion of O to Al.

As indicated in Table 1, if the Ti electrode was stacked, the series resistance was low and the fill factor was high, and the short-circuit current density improved to increase the conversion efficiency. This is considered because the film formation of an aluminum oxide high in resistance generated by oxidation of the Al electrode was suppressed due to the formation of the Ti electrode. After 100 hours from the fabrication, the series resistance increased and the efficiency greatly decreased if the Ti electrode was not provided. As the appearance of the electrode, a change in aspect of the surface appeared as in FIG. 6. According to the result of the XPS analysis, the proportion of oxygen was higher than that of aluminum in the depth direction as in FIG. 9 and FIG. 11, and a signal of the aluminum oxide was observed. This revealed that a thick film of aluminum was formed in the film thickness direction, the surface changed, and the resistance increased. On the other hand, in the case where the Ti electrode was provided, the decrease in the conversion efficiency was not seen as in Table 1 and no change was observed in the appearance of the electrode as in FIG. 5.

From the result of the XPS analysis, as illustrated in FIG. 7 and FIG. 9, the proportion of oxygen was higher than that of aluminum and the aluminum oxide was observed in the third region corresponding to the surface layer of the Al electrode, the proportion of aluminum was higher than that of oxygen in the second region on the inner side, and the proportion of oxygen was higher than that of aluminum and a signal of aluminum oxide was observed in the first region in contact with the Ti electrode. It was found from FIG. 9 that the Ti electrode was a mixed layer of metal titanium and oxide titanium. From the above, the existence of titanium oxide having an n-type semiconductor characteristic existed to increase the rectification, increase the parallel resistance, and increase the fill factor, resulting in increased conversion efficiency. Further, aluminum oxide in the first region and titanium oxide of the Ti electrode improved the durability, and a high proportion of aluminum in the second region maintained the conductivity.

(Example 2)

A photoelectric conversion element was fabricated as in Example 1 except that Ti was formed at a film thickness of 10 nm by the vacuum deposition, Al was subsequently formed at a film thickness of 100 nm by the vacuum deposition, and thereafter Ag was formed at a film thickness of 10 nm by the vacuum deposition in the film formation of the second electrode (counter electrode) in Example 1. It was confirmed that the photoelectric conversion element also had excellent characteristics as those in Example 1.

(Example 3)

A photoelectric conversion element was fabricated as in Example 1 except that Ti was formed at a film thickness of 10 nm by the vacuum deposition, Al was subsequently formed at a film thickness of 100 nm by the vacuum deposition, and then Ti was formed at a film thickness of 10 nm by vacuum deposition in the film formation of the second electrode (counter electrode) in Example 1. It was confirmed that the photoelectric conversion element also had excellent characteristics as those in Example 1.

Note that the configurations of the above-described embodiments are applicable in combination. Further, parts thereof are replaceable. While certain embodiments of the present invention have been described above, these embodiments have been presented by way of example only, and are not intended to limit the scope of the invention. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

**Claims**

1.    A photoelectric conversion element, comprising:

a substrate;
a first electrode arranged on the substrate;
a photoelectric conversion film arranged on the first electrode and containing a perovskite crystal having a composition expressed by
a composition formula: $ABX_3$
where, A represents a monovalent cation of an amine compound, B represents a divalent cation of a metal element, and X represents a monovalent anion of a halogen element;
an electron transport layer arranged on the photoelectric conversion film; and
a second electrode arranged on the electron transport layer, wherein:

the second electrode includes: a first layer arranged on the electron transport layer and containing at least one first metal selected from the group consisting of titanium, tin, zinc, cerium, indium, and niobium and an oxide of the first metal; and a second layer arranged on the first layer and containing a second metal and an oxide of the second metal; and

the second layer includes: a first region existing on the first layer side; a second region existing on the first region and having a lower oxygen concentration than the first region; and a third region existing on the second region and having a higher oxygen concentration than the second region.

2. The element according to claim 1, wherein
the second metal has higher conductivity than the first metal.

3. The element according to claim 2, wherein
the second metal is at least one selected from the group consisting of aluminum, molybdenum, nickel, copper, and silver.

4. The element according to any one of claim 1 to claim 3, wherein
the first region and the third region have bonding between the second metal and oxygen.

5. The element according to any one of claim 1 to claim 4, wherein
the second electrode further includes a third layer arranged on the second layer and containing a third metal.

6. The element according to claim 5, wherein
the third metal contains a metal which is less likely to oxidize than the second metal.

7. The element according to claim 6, wherein
the third metal is at least one selected from the group consisting of copper, silver, and gold.

8. The element according to claim 5, wherein
the third metal contains a metal which is more likely to form a passive state than the second metal.

9. The element according to claim 8, wherein
the third metal is at least one selected from the group consisting of titanium, aluminum, and molybdenum.

# FIG. 1

# FIG. 2

# FIG. 3

**EXAMPLE 1 (WITH Ti)**

- - - - INITIAL CONVERSION EFFICIENCY

——— CONVERSION EFFICIENCY AFTER 100 HOURS

# FIG. 4

**COMPARATIVE EXAMPLE 1 (WITHOUT Ti)**

- - - - INITIAL CONVERSION EFFICIENCY

——— CONVERSION EFFICIENCY AFTER 100 HOURS

EP 4 503 889 A1

# FIG. 5

EXAMPLE 1 (WITH Ti)

# FIG. 6

COMPARATIVE EXAMPLE 1 (WITHOUT Ti)

# FIG. 7

EXAMPLE 1 (WITH Ti)

$Al_2O_3$     Al

THIRD REGION

SECOND REGION

FIRST REGION

80    78    76    74    72    70

Binding Energy (eV)

# FIG. 8

EXAMPLE 1 (WITH Ti)

Ti          Ti

TiOx    TiOx

470    465    460    455    450

# FIG. 9

EXAMPLE 1 (WITH Ti)

# FIG. 10

COMPARATIVE EXAMPLE 1 (WITHOUT Ti)

# FIG. 11

COMPARATIVE EXAMPLE 1 (WITHOUT Ti)

**EP 4 503 889 A1**

| | Europäisches Patentamt |
| | European Patent Office |
| | Office européen des brevets |

# EUROPEAN SEARCH REPORT

Application Number

EP 24 16 2998

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ZHAO LIANFENG ET AL: "Redox Chemistry Dominates the Degradation and Decomposition of Metal Halide Perovskite Optoelectronic Devices", ACS ENERGY LETTERS, vol. 1, no. 3, 25 August 2016 (2016-08-25), pages 595-602, XP093200094, American Chemical Society ISSN: 2380-8195, DOI: 10.1021/acsenergylett.6b00320 * page 596 - page 599; figure 1 * & Zhao Lianfeng ET AL: "Supporting Information. Redox Chemistry Dominates the Degradation and Decomposition of Metal Halide Perovskite Optoelectronic Devices", ACS Energy Letters, vol. 1, no. 3, 9 September 2016 (2016-09-09), pages 595-602, XP093200096, American Chemical Society ISSN: 2380-8195, DOI: 10.1021/acsenergylett.6b00320 * page 9 * ----- -/-- | 1-9 | INV. H10K30/40 H10K30/81 |

| | | | TECHNICAL FIELDS SEARCHED (IPC) |
|---|---|---|---|
| | | | H10K |

The present search report has been drawn up for all claims

| Place of search | Date of completion of the search | Examiner |
|---|---|---|
| The Hague | 30 August 2024 | Tena Zaera, Ramon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 24 16 2998

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CAO HUANQI ET AL: "Stabilization mechanisms of aluminum-titanium bilayer cathodes in organic solar cells", APPLIED PHYSICS LETTERS, vol. 103, no. 14, 30 September 2013 (2013-09-30), XP093200095, 2 Huntington Quadrangle, Melville, NY 11747 ISSN: 0003-6951, DOI: 10.1063/1.4824209 Retrieved from the Internet: URL:https://pubs.aip.org/aip/apl/article-pdf/doi/10.1063/1.4824209/13194945/143305_1_online.pdf> * citation 6: D2a; figures 2,3; table I * | 1-9 | |
| T | HUANQI CAO ET AL: "Titanium-Aluminum Bilayer Cathode for Small-Molecular Organic Solar Cells with Prolonged Life upon Exposure to Air", JAPANESE JOURNAL OF APPLIED PHYSICS, JAPAN SOCIETY OF APPLIED PHYSICS, JP, vol. 52, no. 4R, 1 April 2013 (2013-04-01), pages 40202.1-40202.3, XP001585021, ISSN: 0021-4922, DOI: 10.7567/JJAP.52.040202 [retrieved on 2013-03-14] * page 1 * | 1-4 | |
| A | Helmenstine Anne Marie: "Table of Electrical Resistivity and Conductivity", , 14 October 2017 (2017-10-14), XP093200053, Retrieved from the Internet: URL:https://www.thoughtco.com/table-of-electrical-resistivity-conductivity-608499 * page 3 * | 2 | TECHNICAL FIELDS SEARCHED (IPC) |

-/--

The present search report has been drawn up for all claims

| Place of search | Date of completion of the search | Examiner |
|---|---|---|
| The Hague | 30 August 2024 | Tena Zaera, Ramon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .........................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 24 16 2998

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SANEHIRA ERIN M. ET AL: "Influence of Electrode Interfaces on the Stability of Perovskite Solar Cells: Reduced Degradation Using MoO x /Al for Hole Collection", ACS ENERGY LETTERS, vol. 1, no. 1, 19 April 2016 (2016-04-19), pages 38-45, XP055921658, American Chemical Society ISSN: 2380-8195, DOI: 10.1021/acsenergylett.6b00013 * page 39 - page 43; figure 1 * | 1-9 | |
| A | & SANEHIRA ERIN M. ET AL: "Supporting Information: Influence of Electrode Interfaces on the Stability of Perovskite Solar Cells: Reduced Degradation Using MoO x /Al for Hole Collection", ACS ENERGY LETTERS, vol. 1, no. 1, 8 July 2016 (2016-07-08), pages 38-45, XP093200119, American Chemical Society ISSN: 2380-8195, DOI: 10.1021/acsenergylett.6b00013 * page 2 - page 8; figure S8 * | 1-9 | |
| A | CHEN TAO ET AL: "Efficient Perovskite Solar Cells with Titanium Cathode Interlayer", SOLAR RRL, vol. 2, no. 11, 16 August 2018 (2018-08-16), XP093200101, ISSN: 2367-198X, DOI: 10.1002/solr.201800167 Retrieved from the Internet: URL:https://api.wiley.com/onlinelibrary/td m/v1/articles/10.1002%2Fsolr.201800167> * page 2 - page 4; figures 1,3 * | 1-9 | |

**TECHNICAL FIELDS SEARCHED (IPC)**

-/--

The present search report has been drawn up for all claims

| Place of search | Date of completion of the search | Examiner |
|---|---|---|
| The Hague | 30 August 2024 | Tena Zaera, Ramon |

EPO FORM 1503 03.82 (P04C01)

# EUROPEAN SEARCH REPORT

Europäisches
Patentamt
European
Patent Office
Office européen
des brevets

**Application Number**

EP 24 16 2998

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 101 717 430 B1 (GWANGJU INST SCIENCE & TECH [KR]) 27 March 2017 (2017-03-27) * paragraphs [0039] - [0052]; figures 1a-e * | 1-9 | |

- - - - -

**TECHNICAL FIELDS SEARCHED (IPC)**

The present search report has been drawn up for all claims

| Place of search | Date of completion of the search | Examiner |
|---|---|---|
| The Hague | 30 August 2024 | Tena Zaera, Ramon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                            

& : member of the same patent family, corresponding document

EPO FORM 1503 03.82 (P04C01)

# EP 4 503 889 A1

EP 24 16 2998

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2024

| Patent document cited in search report | Publication date | Patent family member(s) | Publication date |
|---|---|---|---|
| KR 101717430 B1 | 27-03-2017 | NONE | |

For more details about this annex : see Official Journal of the European Patent Office, No. 12/82